# EUROPEAN PATENT SPECIFICATION

(11) **EP 3 499 487 B1**
(45) Date of publication and mention of the grant of the patent: **19.01.2022**
(21) Application number: 18210055.2
(22) Date of filing: 04.12.2018
(51) Int. Cl.: G09F 9/33, G09F 13/22, H01L 27/32

(54) **A SUPPORT STRUCTURE FOR LIGHT RADIATION SOURCES, CORRESPONDING DEVICE AND METHOD**
STÜTZSTRUKTUR FÜR LICHTSTRAHLUNGSQUELLEN, ZUGEHÖRIGE VORRICHTUNG UND VERFAHREN
STRUCTURE SUPPORT POUR SOURCES DE RAYONNEMENT LUMINEUX, DISPOSITIF ET PROCÉDÉ CORRESPONDANTS

(30) Priority: 12.12.2017 IT 201700143214
(43) Date of publication of application: 19.06.2019
(73) Proprietor: OSRAM GmbH, 80807 München (DE); OSRAM S.P.A. - SOCIETA' RIUNITE OSRAM EDISON CLERICI, 20126 Milano (IT)
(72) Inventor: GRIFFONI, Alessio, I-30030 Fossò (Venezia) (IT); BALDO, Mr. Lorenzo, I-31040 Giavera del Montello (Treviso) (IT); PEZZATO, Mr. Luigi, I-31000 Treviso (IT)
(74) Representative: Bosotti, Luciano

(56) References cited:
- US-A1- 2004 100 680
- US-A1- 2014 085 556

## Description

### Technical field

The description refers to possible uses of electrically-powered light radiation sources, for example, solid state light radiation sources such as LED sources.

One or more embodiments can be applied to light-permeable devices comprising LED arrays (e.g. matrices).

### Technological background

Continuous improvements in display devices open up new avenues of development for generating digital-type graphical representations (e.g. signs and symbols - "signage").

In this regard (and without limiting intentions) we can refer to the use in the promotional field, with the possibility of optimizing the use of advertising spaces, improving their visibility and, consequently, the effectiveness of the contents conveyed through these advertising spaces.

For example, displays are now available - such as screens, matrices, light strips and so on - that combine characteristics of light permeability (transparency) and flexibility, and that use traditional solid-state light radiation sources such as LEDs.

These devices can be used to create light tracks with trajectories of various kinds (including curves or composites), which can be applied quickly and reliably on practically any surface: this allows providing solutions, without particular effort, which are able to attract the attention of observers.

Particularly appreciated in this regard is the availability of light-permeable structures (for example, transparent) which allow visualization of what is being displayed, while retaining the vision of what is behind the display. In practice, the displayed graphics appear as if reproduced on glass through which objects are visible that are behind the glass itself.

This type of display presents interesting dynamic features, with, for example, the possibility of displaying information that overlaps a physical object (viewed through the display), for example, taken from the web, presented on the display itself.

In such an application context, the ability to produce electrically-conductive formations (for example, for supplying and/or selectively directing the light radiation sources of the display), with possible flexibility characteristics, assumes importance, without these electrically-conductive formations resulting as an obstacle to the observation or being perceivable in an unattractive way by those observing the display.

In this regard, it has been proposed to produce these electrically-conductive formations (for example, interconnection lines) on flexible and transparent substrates using Transparent Conducting Film (TCF). These are thin films that are electrically-conductive and optically transparent, and which may include, for example, materials such as Indium Tin Oxide (ITO).

However, such a material has drawbacks linked to the reduced electrical-conductivity (which translates into a limitation of the size of the display device), as well as low resistance to bending and a high cost (a consequence of the high content of indium).

As an alternative, it has been proposed to use other Transparent Conductive Oxides (TCO) such as indium and zinc oxide (IOZ) or aluminum and zinc oxide (AZO). These materials have an electrical conductivity similar to that of indium and tin oxide (ITO) discussed above, at a lower cost. However, these are oxides that can only be deposited in fairly thin layers (with a thickness that does not exceed one micron, 1 µm = 10⁻⁶ m) as they are materials deposited by means of sputtering.

The use of conductive polymers, for example, 3,4-ethylenedioxythiophene or PEDOT or poly(styrene sulphonate) or PSS has also been proposed. These materials have good flexibility, with a degree of conductivity lower than that of transparent conductive oxides, compensated by a reduced absorption of the visible spectrum, which facilitates their use as transparent conductors in display devices. These materials, although transparent, absorb part of the visible spectrum with a significant absorption level in the medium and near infrared.

To such a panorama we can add some nanomaterials that have a good degree of mechanical strength, such as CNT (Conductive Nano-Transparent) thin films. The possible short-term use of these materials as a basis for transparent conductive films (TCF), however, clashes with various factors related to the industrial use, both in terms of performance and cost. The reduction of production costs, together with improvements in conductivity (lower than that of metals but higher than that of other transparent conductive films) will likely make these materials important for producing displays on large surfaces.

Currently, films in the form of graphene with various critical aspects related to manufacturing techniques are also being studied. Metal nanowires (nanowires) are promising due to their high degree of conductivity. However, this positive aspect is negatively balanced by a high value of obfuscation (haze), which reduces transparency, making these solutions difficult to be compatible with various applications.

Other critical aspects stand out as related to environmental stability and high surface roughness, factors which are susceptible to prevent the use in various application sectors.

Metal nanostructures (in the form of both nanowires and grids) have openings (i.e. spacing between adjacent electrically-conductive formations or tracks) that are fairly large, which may require combination with electrically-conductive transparent structures having a greater degree of continuity, such as PEDOT or similar solutions.

Document US 2014/085556 A1 discloses a display for an electronic device that has a layer of liquid crystal material interposed between a color filter layer and a thin-film-transistor layer. The thin-film-transistor layer may have a substrate with an upper surface and a lower surface. A display driver circuit may be mounted on an inactive border region of the lower surface of the thin-film transistor substrate. Display pixels may form an array in a central active region of the display. A grid of metal gate and data lines may distribute signals from the display driver circuit and gate driver circuitry to the display pixels. A grid of non-reflecting lines may be interposed between the grid of metal lines and the lower surface.

### Object and summary

One or more embodiments aim to contribute to providing improved solutions that are able to overcome the drawbacks outlined above.

According to the invention, this object is achieved thanks to a structure having the characteristics referred to in claim 1 that follows.

In accordance with the invention, a corresponding device (e.g. a display with solid-state light radiation sources) as per claim 7 and a corresponding method as per claim 9 are provided.

The claims form an integral part of the technical disclosure provided here in relation to one or more embodiments.

One or more embodiments make it possible to achieve one or more of the following advantages:
- possibility of producing electrically-conductive formations (for example, lines or tracks) capable of combining a high degree of conductivity with a certain thickness (for example, greater than 5 µm; 1 µm = 10⁻⁶ m ) and a good flexibility; in this way, it is possible to produce large-area arrays or matrices (for example, for LED displays) maintaining good flexibility characteristics;
- possibility of observing what is displayed while continuing to see what is behind the display plane (which is light-permeable) without appreciably perceiving the presence of electrically-conductive formations.

### Brief description of the figures

One or more embodiments will be now described, purely by way of non-limiting example, with reference to the attached figures, wherein:
- Figure 1 is a general view of a display device which can be made according to one or more embodiments,
- Figure 2 comprises three portions indicated, respectively, by a), b) and c), which illustrate various possible embodiments,
- Figures 3 to 6 - each comprising two portions indicated, respectively, by a) and b) - is exemplary of various implementation modes of embodiments, and
- Figure 7, comprising eleven portions indicated, respectively, by letters from a) to m), is an example of the high degree of flexibility of use demonstrated by one or more embodiments.

It will be appreciated that, for clarity and simplicity of representation, the various figures may not be reproduced on the same scale.

### Detailed description

The following description illustrates various specific details in order to provide a thorough understanding of various examples of embodiments according to the description. The embodiments can be obtained without one or more of the specific details, or with other methods, components, materials, etc. In other cases, known structures, materials or operations are not illustrated or described in detail so that the various aspects of the embodiments and not rendered unclear.

The reference to "an embodiment" in the context of the present description indicates that a particular configuration, structure or characteristic described in relation to the embodiment is included in at least one embodiment. Thus, sentences such as "in an embodiment", which may be present at various points in the present description, do not necessarily refer to exactly the same embodiment. Moreover, particular configurations, structures or characteristics can be combined in any suitable way in one or more embodiments.

The references used herein are provided simply for convenience and, therefore, do not define the field of protection or scope of the embodiments.

In the figures, reference 10 indicates - in its entirety - a laminar element usable as a display device and comprising a laminar substrate 12 of a light-permeable, possibly flexible material.

This can be, for example, a film of transparent plastic material such as, for example, polyethylene terephthalate (PET), polyethylene naphthalate (PEN), polyimide (PI), polytetrafluoroethylene (PTFE) or an ultra-thin and flexible glass material referred to as Ultra-Thin Flexible Glass.

Electrically-powered light radiation sources 14 are distributed on the substrate 12 (according to an array that can be of any size, conformation or distribution).

In one or more embodiments, it is possible to use solid state light radiation sources, such as, for example, LED sources.

Sources of this type may emit colored light radiation, operating, for example, according to an RGB scheme or any other standard that can be used for generating colored light radiation and/or white light radiation, with the possibility of controlling the correlated color temperature (CCT).

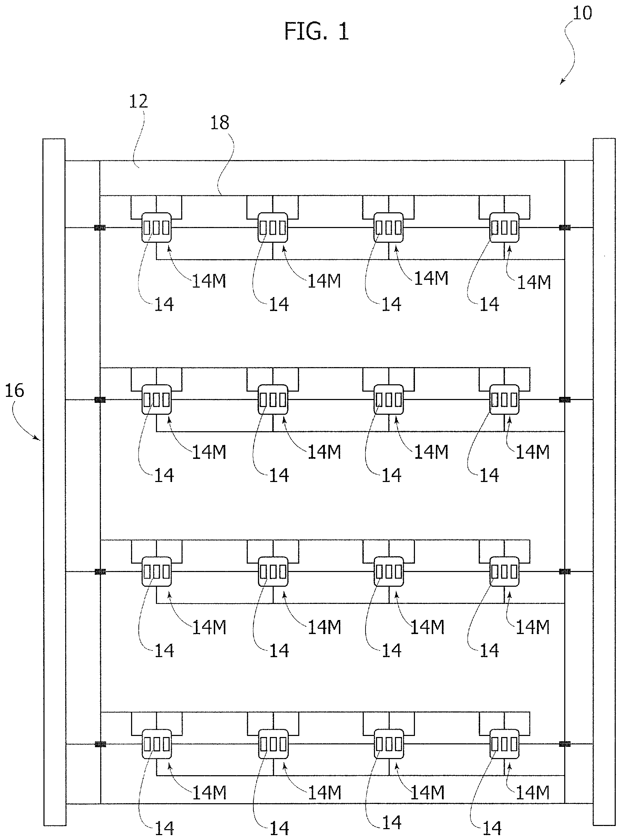

Devices such as the one shown in Figure 1 can be driven (in a way known per se) to reproduce signs or graphics (lines, symbols, or images, so-called "signage" applications), with the possibility of ensuring that what is reproduced by means of sources 14 can be observed on the device 10, preserving the vision of what is behind the device 10 itself, thanks to the fact that the substrate 12 is light-permeable (for example, transparent).

The substrate 12 can be supported, for example, at opposite sides or possibly along the whole contour of the device 10 by frame formations 16.

Operation of the light radiation sources 14 is made possible (according to criteria known per se, so as not to require a detailed description here), both in relation to the electrical power supply of the sources, and (possibly) in relation to control functions, for example, light intensity, color, possible stroboscopic movement effects, etc., through electrically-conductive formations 18, which extend, for example, in the form of lines or tracks on one (or possibly both) the faces of the substrate 12.

One or more embodiments aim to provide electrically-conductive formations 18, which, on one hand, can exhibit a good level of electrical conductivity, possibly in conjunction with flexibility features - which allow it to be used on flexible substrates 12 and, on the other hand, are not very visible (virtually invisible) for those observing the device 10, so as not to hinder the vision of what is observed through the substrate 12 with the display produced by the overlapping sources 14.

One or more embodiments are based on the recognition of the fact that formations, such as the formations 18, can be made (in practice with any geometry), with a high degree of conductivity and flexibility characteristics, using electrically-conductive materials traditionally used for making printed circuits or contacts in integrated circuits.

They can be made, for example, using metals such as copper or electrically-conductive inks.

For example, these conventional solutions allow formations 18 to be produced with different techniques such as, for example:
- chemical or physical etching of copper (for example, with rolled-annealed - RA technology, i.e. by means of high density electrolytic deposition - HD ED), possibly followed by surface finishing.
- plating (for example, electroless) with a material such as copper, also in this case possibly followed by surface finishing,
- printing (for example, screen printing) of flexible electrically-conductive inks, including for example, metal (nano)particles of materials such as silver, silver-coated copper, or copper.

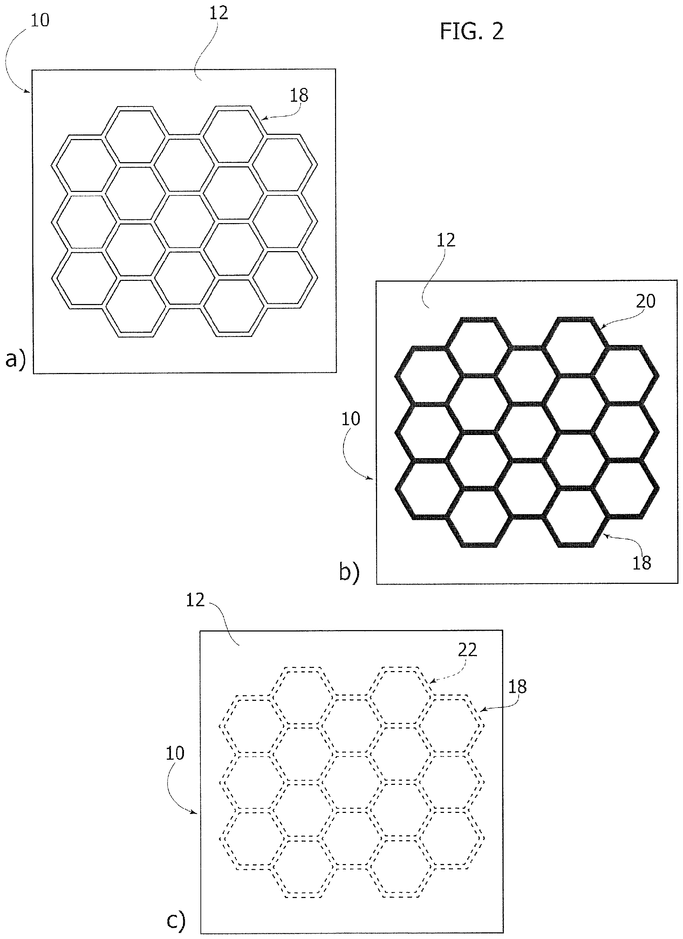

However, it has been observed that these materials, when used to make formations 18 on a substrate 12 (see, for example, part a) of Figure 2), may have the drawback of a high reflectivity of the light, of a mirrored or specular type, so as to make them markedly perceptible when the device 10 is observed.

As schematically exemplified in Figure 2, the electrically-conductive formations 18, made with any of the aforementioned technologies, are coated on the side opposite the substrate 12 with an anti-reflective covering capable of comprising, for example:
- a light-impermeable masking material 20, e.g. opaque (see, for example, part b) of Figure 2),
- an at least partially light-impermeable masking material 20, e.g. frosted (see, for example, part c) of Figure 2),

This is carried out in order to reduce and virtually eliminate the reflective characteristics of the (metal) material of the formations 18.

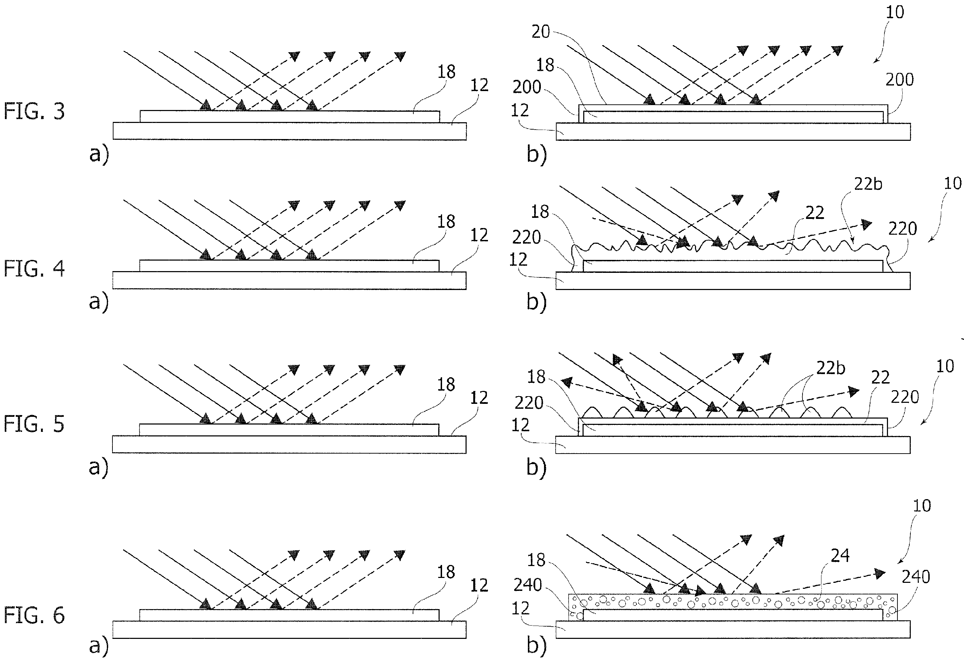

Figures 3 to 6 illustrate various possible embodiments of the solution exemplified in general terms in parts a) b) and c) of Figure 2.

In all four Figures 3 to 6, the part on the left - denoted by a) - represents the substrate 12 of light-permeable (possibly flexible) material on which electrically-conductive formations 18 have been made (for example, by adopting any of the conventional technologies referred to above); it will be appreciated, moreover, that, as already said, the distribution, conformation and topology of the electrically-conductive formations 18 can be of any type.

For example, Figure 2 refers to electrically-conductive formations 18 distributed according to a honeycomb grid (although, as already mentioned, this morphology can be of any type).

Figure 3 exemplifies a solution - in essential terms - roughly corresponding to the solution exemplified in part b) of Figure 2, i.e. with a light-impermeable material (for example, a dark opaque material 20, such as a reserve material for soldering, of the type currently known as "solder resist") applied, for example, by screen printing, to the electrically-conductive formations 18 so as to reduce their reflective characteristics. Part b) of Figure 3 exemplifies the possibility that the anti-reflective covering 20a also extends, as indicated by 200, on the side walls of the electrically-conductive formations 18.

Part b) of Figures 4, 5 and 6, on the other hand, exemplifies the possibility of using, according to similar modalities, a "frosted" 22 and/or light-diffusive material 24, comprising, for example, silicone-based elastomers for producing the aforementioned anti-reflective masking effect of the electrically-conductive formations 18, reducing their degree of reflectivity thanks to the surface roughness 22b of the material 22 and/or to the diffusivity of the material 24.

Without referring to any specific theory in this regard, it will be appreciated that, in embodiments as exemplified in Figure 3, the effect of reducing the reflectivity (anti-reflective effect) of the electrically-conductive formations 18 is achieved thanks to absorption of the light radiation by the opaque layer 20.

In embodiments as exemplified in Figure 4 (and in Figure 5), this result is, instead, achieved thanks to a diffused reflection effect due to the surface roughness 22b of the material 22 which, once again, can be extended onto the sides of the electrically-conductive formations as indicated by 220. In one or more embodiments, the layer 22 can be applied by printing or by a process of the type identified as a "potting" process, with the possibility of following with a mechanical frosting finishing treatment.

Figure 5 exemplifies, again according to the same modalities adopted in Figures 3 and 4, the possibility of producing the opaque or anti-reflective action, previously exemplified by using a layer of elastomeric material such as, for example, silicone 22 with a surface embossing 22b which, instead of a pseudo-random pattern, as in the case of the solution exemplified in Figure 4, has a regular or semi-regular distribution of surface ridges.

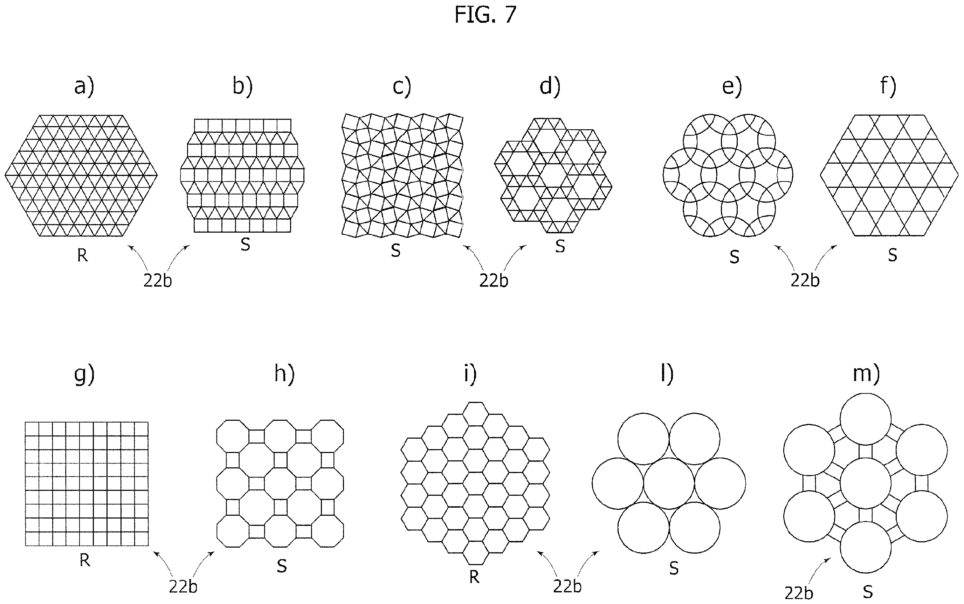

As will be seen below with reference to Figure 7, this can be, for example, a surface embossing comprising a regular array of polygonal formations identical or different from each other, with the vertices of this embossing able to be reproduced according to a regular or almost regular pattern.

For example, the ridges 22b may have variable dimensions in a fairly wide range (from 0.5 µm - 1 µm = 10⁻⁶ m to 1 mm). This is carried out with the possibility of giving rise to a diffusion effect of the light radiation such as to attenuate (and virtually eliminate) the specular reflectivity of the formations 18.

In this case as well, the covering 22 may extend onto the sides of the electrically-conductive formations 18, as exemplified by 220 in Figure 5.

Embodiments as exemplified in Figure 6 envisage applying a layer 24 of a light-permeable material (e.g. a transparent elastomer such as a silicone elastomer) loaded with particles having a light-diffusive effect (e.g. particles of alumina or titanium dioxide) able, once again, to mitigate the reflective characteristics of the electrically-conductive formations 18. In this case as well, the layer 24 may extend onto the sides of the electrically-conductive formations, as indicated by 240.

In one or more embodiments, the layer 24 can also be deposited on the electrically-conductive formations 18 with a process such as a potting process.

Figure 7 exemplifies possible morphologies that can be used for the ridges indicated with 22b in part b) of Figure 5.

For example, parts a), g) and i) of Figure 7 exemplify configurations identifiable as regular configurations (indicated with R), while parts b), c), d), e), f), h), 1) and m) exemplify configurations definable as semiregular configurations (indicated with S).

The regular conformations R may comprise a single type of ridge, for example, polygonal, while the semi-regular configurations S comprise polygonal formations of different types, with possible overall identical vertex parts.

Without prejudice to the underlying principles of the invention, the details of construction and the embodiments may vary, even significantly, with respect to those described here, purely by way of non-limiting example, without departing from the scope of the invention.

The scope of protection is determined by the attached claims.

**LIST OF REFERENCE SIGNS**

| | |
|---|---|
| Support structure | 10 |
| Laminar substrate | 12 |
| Light radiation sources | 14 |
| Mounting locations | 14M |
| Frame formations | 16 |
| Electrically-conductive formations | 18 |
| Anti-reflective covering | 20, 22, 24 |
| Sides of the conductive formations | 200, 220, 240 |
| Surface embossing | 22b |

## Claims

1. A support structure (10) for electrically-powered light radiation sources (14), the structure (10) comprising:
- a light-permeable laminar substrate (12) having opposed surfaces with light radiation source mounting locations (14M) at at least one of the opposed surfaces,
- electrically-conductive formations (18) extending towards the light radiation source mounting locations (14M) at at least one of the opposed surfaces of the laminar substrate (12), the electrically-conductive formations (18) comprising light-reflective material, wherein the electrically-conductive formations (18) comprise etched or deposited electrically-conductive material,
and
- an anti-reflective covering (20, 22, 24) applied onto the electrically-conductive formations (18) on the side opposite the light-permeable laminar substrate (12) .

2. The support structure (10) of claim 1, wherein the anti-reflective covering (20, 22, 24) extends over the sides (200, 220, 240) of the electrically-conductive formations (18).

3. The support structure (10) of claim 1 or claim 2, wherein the electrically-conductive formations (18) comprise metal material.

4. The support structure (10) of any of the previous claims, wherein the anti-reflective covering comprises light-impermeable material (20) applied onto the electrically-conductive formations (18).

5. The support structure (10) of any of claims 1 to 3, wherein the anti-reflective covering comprises light-permeable material (22) applied onto the electrically-conductive formations (18), the anti-reflective covering having a light-diffusive surface sculpturing (22b).

6. The support structure (10) of any of claims 1 to 3, wherein the anti-reflective covering comprises light-diffusive, light-permeable material (24).

7. A light radiation source, comprising:
- a support structure (10) according to any of claims 1 to 6, and
- electrically-powered light-radiation sources, preferably solid-state sources such as LED sources (14), applied at said light radiation source mounting locations (14M).

8. The light radiation source of claim 7, wherein the light radiation source mounting locations (14M) are distributed over the laminar substrate (12) as a display array.

9. A method of providing a display device, the method comprising:
- providing a support structure (10) for electrically-powered light radiation sources (14) according to any of claims 1 to 6, with said light radiation source mounting locations (14M) distributed over the laminar substrate (12) as a display array,
- applying electrically-powered light radiation sources, preferably solid state sources such as LED sources (14), at said light radiation source mounting locations (14M).

## Patentansprüche

1. Trägerstruktur (10) für elektrisch betriebene Lichtstrahlungsquellen (14), die Struktur (10) umfassend:
- ein lichtdurchlässiges, laminares Substrat (12), das gegenüberliegende Oberflächen mit Lichtstrahlungsquellen-Befestigungsstellen (14M) an mindestens einer der gegenüberliegenden Oberflächen aufweist,
- elektrisch leitende Ausbildungen (18), die sich zu den Lichtstrahlungsquellen-Befestigungsstellen (14M) an mindestens einer der gegenüberliegenden Oberflächen des laminaren Substrats (12) erstrecken, wobei die elektrisch leitenden Ausbildungen (18) lichtreflektierendes Material umfassen, wobei die elektrisch leitenden Ausbildungen (18) geätztes oder abgeschiedenes elektrisch leitendes Material umfassen, und
- eine antireflektierende Abdeckung (20, 22, 24), die auf die elektrisch leitenden Ausbildungen (18) auf der gegenüberliegenden Seite des lichtdurchlässigen laminaren Substrats (12) aufgebracht ist.

2. Trägerstruktur (10) nach Anspruch 1, wobei sich die antireflektierende Abdeckung (20, 22, 24) über die Seiten (200, 220, 240) der elektrisch leitenden Ausbildungen (18) erstreckt.

3. Trägerstruktur (10) nach Anspruch 1 oder Anspruch 2, wobei die elektrisch leitenden Ausbildungen (18) metallisches Material umfassen.

4. Trägerstruktur (10) nach einem der vorhergehenden Ansprüche, wobei die antireflektierende Abdeckung lichtundurchlässiges Material (20) umfasst, das auf die elektrisch leitenden Ausbildungen (18) aufgebracht ist.

5. Trägerstruktur (10) nach einem der Ansprüche 1 bis 3, wobei die antireflektierende Abdeckung ein auf die elektrisch leitenden Ausbildungen (18) aufgebrachtes lichtdurchlässiges Material (22) umfasst, wobei die antireflektierende Abdeckung eine lichtdiffuse Oberflächenstrukturierung (22b) aufweist.

6. Trägerstruktur (10) nach einem der Ansprüche 1 bis 3, wobei die antireflektierende Abdeckung aus lichtdiffusem, lichtdurchlässigem Material (24) besteht.

7. Lichtstrahlungsquelle, umfassend:
- eine Trägerstruktur (10) nach einem der Ansprüche 1 bis 6, und
- elektrisch betriebene Lichtstrahlungsquellen, vorzugsweise Festkörperquellen wie LED-Quellen (14), die an den Lichtstrahlungsquellen-Befestigungsstellen (14M) angebracht sind.

8. Lichtstrahlungsquelle nach Anspruch 7, wobei die Lichtstrahlungsquellen-Befestigungsstellen (14M) über das laminare Substrat (12) als eine Anzeigeanordnung verteilt sind.

9. Verfahren zum Bereitstellen einer Anzeigevorrichtung, das Verfahren umfassend:
- Bereitstellen einer Trägerstruktur (10) für elektrisch betriebene Lichtstrahlungsquellen (14) nach einem der Ansprüche 1 bis 6, wobei die Lichtstrahlungsquellen-Befestigungsstellen (14M) als eine Anzeigeanordnung über das laminare Substrat (12) verteilt sind,
- Anbringen von elektrisch betriebenen Lichtstrahlungsquellen, vorzugsweise Festkörperquellen wie LED-Quellen (14), an den Lichtstrahlungsquellen-Befestigungsstellen (14M).

## Revendications

1. Une structure support (10) pour des sources de rayonnement lumineux électriquement alimentées (14), la structure (10) comprenant :
- un substrat stratifié perméable à la lumière (12) ayant des surfaces opposées avec des emplacements de montage de sources de rayonnement lumineux (14M) sur au moins l'une des surfaces opposées,
- des formations électriquement conductrices (18) s'étendant en direction des emplacements de montage des sources de rayonnement lumineux (14M) sur au moins l'une des surfaces opposées du substrat stratifié (12), les formations électriquement conductrices (18) comprenant un matériau réfléchissant la lumière, les formations électriquement conductrices (18) comprenant un matériau électriquement conducteur gravé ou déposé, et
- une couverture antiréfléchissante (20, 22, 24) appliquée par-dessus les formations électriquement conductrices (18) sur le côté opposé du substrat stratifié perméable à la lumière (12).

2. La structure support (10) de la revendication 1, dans laquelle la couverture antiréfléchissante (20, 22, 24) s'étend au-dessus des côtés (200, 220, 240) des formations électriquement conductrices (18).

3. La structure support (10) de la revendication 1 ou de la revendication 2, dans laquelle les formations électriquement conductrices (18) comprennent un matériau métallique.

4. La structure support (10) de l'une des revendications précédentes, dans laquelle la couverture antiréfléchissante comprend un matériau imperméable à la lumière (20) appliqué par-dessus les formations électriquement conductrices (18).

5. La structure support (10) de l'une des revendications 1 à 3, dans laquelle la couverture antiréfléchissante comprend un matériau imperméable à la lumière (22) appliqué par-dessus les formations électriquement conductrices (18), la couverture antiréfléchissante ayant une texturation de surface pour diffuser la lumière (22b) .

6. La structure support (10) de l'une des revendications 1 à 3, dans laquelle la couverture antiréfléchissante comprend un matériau perméable à la lumière diffusant la lumière (24).

7. Une source de rayonnement lumineux, comprenant :
- une structure support (10) selon l'une des revendications 1 à 6, et
- des sources de rayonnement lumineux électriquement alimentées, de préférence des sources à semi-conducteurs telles que des sources LED (14), appliquées sur lesdits emplacements de montage de sources de rayonnement lumineux (14M).

8. La source de rayonnement lumineux de la revendication 7, dans laquelle les emplacements de montage de sources de rayonnement lumineux (14M) sont distribués sur le substrat stratifié (12) en un réseau d'affichage.

9. Un procédé de production d'un dispositif d'affichage, le procédé comprenant :
- la production d'une structure support (10) pour sources de rayonnement lumineux électriquement alimentées (14) selon l'une des revendications 1 à 6, avec lesdits emplacements de montage de sources de rayonnement lumineux (14M) distribués sur le substrat stratifié (12) en un réseau d'affichage,
- l'application de sources de rayonnement lumineux électriquement alimentées, de préférence des sources à semi-conducteurs telles que des sources LED (14), sur lesdits emplacements de montage de sources de rayonnement lumineux (14M).
